(19) Europäisches Patentamt
European Patent Office
Office européen des brevets

(11) **EP 4 625 721 A1**

(12) **EUROPEAN PATENT APPLICATION**
published in accordance with Art. 153(4) EPC

(43) Date of publication:
**01.10.2025 Bulletin 2025/40**

(21) Application number: **23909758.7**

(22) Date of filing: **17.11.2023**

(51) International Patent Classification (IPC):
*H01R 13/66* (2006.01)

(52) Cooperative Patent Classification (CPC):
**B60L 53/16; H01R 13/66; H05K 7/20**

(86) International application number:
**PCT/CN2023/132266**

(87) International publication number:
**WO 2024/139826 (04.07.2024 Gazette 2024/27)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **30.12.2022 CN 202211725899**

(71) Applicant: **BYD Company Limited**
**Shenzhen, Guangdong 518118 (CN)**

(72) Inventors:
• **WEN, Qi**
**Shenzhen, Guangdong 518118 (CN)**

• **LIANG, Wei**
**Shenzhen, Guangdong 518118 (CN)**
• **LAI, Jinfu**
**Shenzhen, Guangdong 518118 (CN)**
• **ZHAO, Taifeng**
**Shenzhen, Guangdong 518118 (CN)**
• **LIANG, Enxi**
**Shenzhen, Guangdong 518118 (CN)**

(74) Representative: **Taor, Simon Edward William**
**Venner Shipley LLP**
**200 Aldersgate**
**London EC1A 4HD (GB)**

(54) **METHOD FOR HEATING CHARGING SOCKET, AND VEHICLE AND STORAGE MEDIUM**

(57)    A method for heating a charging socket, and a vehicle and a storage medium. The method comprises: determining a charging type of a vehicle, wherein the charging type comprises a first charging type and a second charging type, and the first charging type is different from the second charging type; according to the charging type, selecting a heating assembly corresponding to the charging type from a heating apparatus to serve as a target heating apparatus, wherein the heating apparatus comprises a heat conduction assembly and the heating assembly, the heat conduction assembly is used for conducting heat energy generated during a vehicle charging process to a charging socket, so as to heat the charging socket, and the heating assembly is used for heating the charging socket; and controlling the target heating apparatus to heat the charging socket.

EP 4 625 721 A1

```
┌─────────────────────────────────────────────────────────────┐
│        Determine a charging type of a vehicle                │── S2100
└─────────────────────────────────────────────────────────────┘
                              │
                              ▼
┌─────────────────────────────────────────────────────────────┐
│ Select a heating component corresponding to the charging     │── S2200
│ type from a heating device according to the charging type    │
│ of the vehicle to serve as a target heating device           │
└─────────────────────────────────────────────────────────────┘
                              │
                              ▼
┌─────────────────────────────────────────────────────────────┐
│ Control the target heating device to heat the charging socket│── S2300
└─────────────────────────────────────────────────────────────┘
```

FIG. 2

**Description**

## CROSS-REFERENCE TO RELATED APPLICATIONS

The present disclosure claims priority to and benefits of Chinese Patent Application No. 202211725899.4 filed on December 30, 2022. The entire content of the above-referenced applications is incorporated herein by reference.

## FIELD

Embodiments of the present disclosure relate to the field of vehicle design technologies, and more specifically, to a method for heating a charging socket, a vehicle, and a computer-readable storage medium.

## BACKGROUND

In recent years, the new energy sector comprehensively develops and constantly grows. With strong support of national policies and continuous improvement of environmental awareness of people, electric vehicles are becoming more popular.

In winter, only charging port covers of electric vehicles are heated, to avoid that the charging port covers freeze and cannot be opened. However, it is still possible that charging connectors cannot be pulled out.

## SUMMARY

An objective of the embodiments of the present disclosure is to provide a technical solution for heating a charging socket.

According to a first aspect of the embodiments of the present disclosure, a method for heating a charging socket is provided. The method includes:

determining a charging type of a vehicle, the charging type including a first charging type and a second charging type, and the first charging type being different from the second charging type;
selecting, from a heating device according to the charging type, a heating component corresponding to the charging type to serve as a target heating device, the heating device including a heat conduction component and a heating component, the heat conduction component being configured to conduct heat energy generated during charging of the vehicle to the charging socket to heat the charging socket, and the heating component being configured to heat the charging socket; and
controlling the target heating device to heat the charging socket.

Optionally, the selecting, from a heating device according to the charging type, a heating component corresponding to the charging type to serve as a target heating device includes:

selecting the heat conduction component as the target heating device when the charging type is the first charging type; and
selecting the heating component as the target heating device when the charging type is the second charging type.

Optionally, the first charging type includes first direct current charging, the second charging type includes alternating current charging and second direct current charging, and a power of the first direct current charging is greater than a power of the second direct current charging; and
the determining a charging type of a vehicle includes:

determining that the charging type is the alternating current charging when a first resistance value is a first target value, the first resistance value being a value of a first resistor corresponding to the alternating current charging;
determining that the charging type is the first direct current charging when a second resistance value is a second target value and heat generated by charging the vehicle is greater than or equal to a preset heat threshold; or determining that the charging type is the second direct current charging when the second resistance value is the second target value and the heat generated by charging the vehicle is less than the heat threshold; the second resistance value being a value of a second resistor corresponding to direct current charging.

Optionally, the method further includes:

determining whether the charging socket has a to-be-thawed object; and
the controlling the target heating device to heat the charging socket includes:
controlling, when the charging socket has a to-be-thawed object, the target heating device to heat the charging socket.

Optionally, the determining whether the charging socket of the vehicle has a to-be-thawed object includes:

receiving sensor data collected by a foreign object detection sensor;
determining, according to the sensor data, whether the charging socket has a foreign object;
controlling, in a case in which the charging socket has a foreign object, a camera to photograph the charging socket, to obtain a first image; and
receiving the first image, and determining, according to the first image, whether the foreign object is a to-be-thawed object.

Optionally, the method further includes:

determining whether the charging socket has a to-be-thawed object and whether a current temperature of the charging socket is less than or equal to a preset first temperature threshold; and
the controlling the target heating device to heat the charging socket includes:
controlling, when the charging socket has a to-be-thawed object and the current temperature of the charging socket is less than or equal to the first temperature threshold, the target heating device to heat the charging socket.

Optionally, the determining whether the charging socket has a to-be-thawed object and whether a current temperature of the charging socket is less than or equal to a preset first temperature threshold includes:

controlling a camera to photograph the charging socket, to obtain a first image;
receiving the first image, and determining, according to the first image, whether the charging socket has a to-be-thawed object; and
controlling, in a case in which the charging socket has a to-be-thawed object, the temperature sensor to obtain the current temperature of the charging socket, and determining whether the current temperature of the charging socket is less than or equal to the first temperature threshold.

Optionally, the method further includes:

determining, in a process of controlling the target heating device to heat the charging socket, whether the charging socket has a to-be-thawed object; and
controlling, when the charging socket has no to-be-thawed object, the target heating device to stop heating the charging socket.

Optionally, the determining whether the charging socket has a to-be-thawed object includes:

controlling, in a case in which the current temperature of the charging socket is greater than or equal to a preset second temperature threshold, the camera to photograph the charging socket, to obtain a second image; and
receiving the second image, and identifying, according to the second image, whether the charging socket has a to-be-thawed object.

Optionally, the method further includes:

controlling a temperature sensor to obtain the current temperature of the charging socket; and
selecting a heating mode corresponding to the current temperature from multiple heating modes to serve as a target heating mode; and
the controlling the target heating device to heat the charging socket includes:
controlling the target heating device to heat the charging socket by using the target heating mode.

According to a second aspect of the present disclosure, a vehicle is provided, including a processor and a memory. The memory is configured to store a computer program. The processor is configured to perform the method according to the first aspect of the present disclosure under control by the computer program.

According to a third aspect of the present disclosure, a computer-readable storage medium is provided, having a computer program stored therein. The computer program is executed by a processor to perform the method according to the first aspect of the present disclosure.

According to the embodiments of the present disclosure, in a process of charging a vehicle, a heating component corresponding to a charging type of the vehicle is selected from a heating device to serve as a target heating device, and the target heating device is controlled to heat a charging socket, to resolve a problem that a charging connector is frozen and cannot be pulled out in the process of charging the vehicle. In addition, charging types of the vehicle are distinguished, and different heating components are controlled to heat the charging socket, so that energy for heating the charging socket can be properly allocated.

Other features and advantages of the present disclosure will become apparent from the following detailed description of exemplary embodiments of the present disclosure with reference to the accompanying drawings.

## BRIEF DESCRIPTION OF THE DRAWINGS

Accompanying drawings are incorporated into and constitute a part of this specification, show embodiments that conform to the present disclosure, and are used together with this specification to describe the principle of the present disclosure.

FIG. 1 is a schematic structural diagram of a charging socket component that can implement an embodiment of the present disclosure;
FIG. 2 is a flowchart of a method for heating a charging socket according to an embodiment of the present disclosure;
FIG. 3 is a flowchart of an example of a method for heating a charging socket according to an embodiment of the present disclosure; and
FIG. 4 is a principle diagram of a vehicle according to an embodiment of the present disclosure.

## DETAILED DESCRIPTION

Various exemplary embodiments of the present disclosure are now be described in detail with reference to the accompanying drawings. It should be noted: relative arrangements, numerical expressions, and numerical values of components and steps set forth in these embodiments do not limit the scope of the present disclosure unless specifically stated otherwise.

The following descriptions of at least one exemplary embodiment are merely illustrative, and in no way constitute any limitation on the present disclosure and application or use of the present disclosure.

Technologies, methods, and devices known to those of ordinary skill in related arts may not be discussed in detail, but where appropriate, the technologies, the methods, and the devices should be considered as a part of the specification.

In all examples shown and discussed herein, any specific value should be construed as merely illustrative and not as limitations. Therefore, other examples of exemplary embodiments may have different values.

It should be noted that similar reference numerals and letters refer to similar items in the following accompanying drawings. Therefore, once an item is defined in one accompanying drawing, the item does not need to be further discussed in subsequent accompanying drawings.

< Hardware configuration >

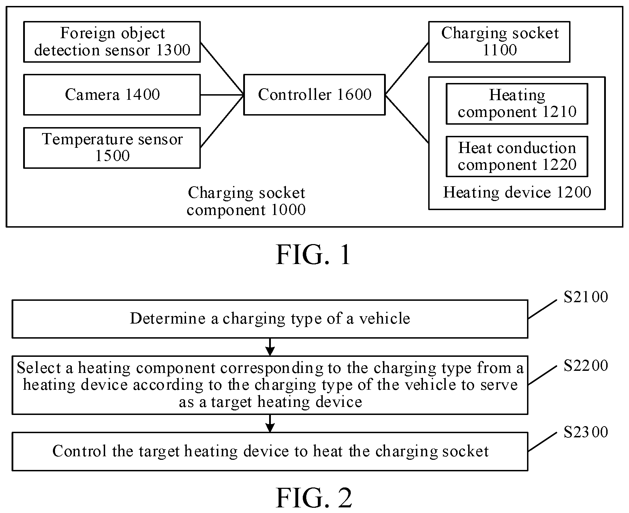

FIG. 1 is a schematic structural diagram of a charging socket component that can implement an embodiment of the present disclosure.

As shown in FIG. 1, a charging socket component 1000 in this embodiment may include a charging socket 1100, a heating device 1200, a foreign object detection sensor 1300, a camera 1400, a temperature sensor 1500, and a controller 1600.

The charging socket 1100 in this embodiment may be an integrated charging socket in which an alternating current charging socket and a direct current charging socket are integrated, or may include an alternating current charging socket and a direct current charging socket that are disposed in one charging port.

The heating device 1200 in this embodiment may include a heating component 1210 and a heat conduction component 1220.

The heating component 1210 is configured to convert electric energy into heat energy, so as to heat the charging socket 1100 through the generated heat energy.

In an example, the heating component 1210 may be a heating patch that has good insulation performance, meets a particular pressure resistance level, and has a relatively high heat conduction coefficient.

In another example, the heating component 1210 may alternatively be a heating resistor.

The heat conduction component 1220 may be configured to absorb heat emitted by a direct current charging conductor, recycle the heat, and heat the charging socket 1100. Specifically, the heat conduction component 1220 may transfer heat energy generated during charging of a vehicle to the charging socket 1100, so as to heat the charging socket 1100.

The direct current charging conductor connected to the heat conduction component 1220 may be a cable in a direct current charging loop, and may be specifically a copper wire, an aluminum wire, an aluminum rod, a copper rod, a copper bar, an aluminum bar, or the like. The aluminum rod, the copper rod, the copper bar, and the aluminum bar have better heat dissipation performance, and can better conduct heat to the heat conduction component 1220.

A heat conduction material having a high heat conduction coefficient, such as a heat conduction adhesive (liquid) or a heat conduction mud, may be disposed between the heat conduction component 1220 and the direct current charging conductor, to transfer the heat in the direct current charging conductor to the heat conduction component 1220 for recycling.

The foreign object detection sensor 1300 may be configured to detect whether a foreign object attaches to the charging socket 1100.

The camera 1400 is configured to photograph the charging socket 1100, to obtain a first image, so that the vehicle determines, according to the first image, whether a foreign object attaching to the charging socket 1100 is a to-be-thawed object.

The temperature sensor 1500 is configured to detect a temperature of the charging socket 1100.

The controller 1600 is configured to comprehensively determine, according to data collected by the foreign object detection sensor 1300, the camera 1400, and the temperature sensor 1500, whether the charging socket has a to-be-thawed object; and in a case in which it is determined that the charging socket has a to-be-thawed object, select, from the heating device 1200, a heating component, that is, the heating component 1210 or the heat conduction component 1220, corresponding to a charging type of the vehicle, to heat the charging socket 1100, so that the to-be-thawed object of the charging socket 1100 is thawed.

< Method embodiment >

FIG. 2 shows a method for heating a charging socket according to an embodiment. In an example, the method may be implemented by a vehicle, the vehicle may include the charging socket component 1000 shown in FIG. 1, and the method may be implemented by the controller 1600 shown in FIG. 1.

As shown in FIG. 2, the method for heating a charging socket according to this embodiment may include the following step S2100 to step S2300.

Step S2100: A charging type of a vehicle is determined.

The charging type may include a first charging type and a second charging type, and the first charging type is different from the second charging type.

In this embodiment, the charging type of the vehicle may be the first charging type, or may be the second charging type.

In an embodiment of the present disclosure, the first charging type includes first direct current charging, the second charging type includes alternating current charging and second direct current charging, and a power of the first direct current charging is greater than a power of the second direct current charging.

In an embodiment of the present disclosure, the determining a charging type of a vehicle may include: determining that the charging type of the vehicle is the alternating current charging when a first resistance value is a first target value, the first resistance value being a value of a first resistor corresponding to the alternating current charging; determining that the charging type is the first direct current charging when a second resistance value is a second target value and heat generated by charging the vehicle is greater than or equal to a preset heat threshold; or determining that the charging type is the second direct current charging when the second resistance value is the second target value and the heat generated by charging the vehicle is less than the heat threshold; the second resistance value being a value of a second resistor corresponding to direct current charging.

In this embodiment, the first resistor may be a resistor connected between a first pin and a ground pin of the charging socket, and the second resistor may be a resistor connected between a second pin and the ground pin of the charging socket.

When the vehicle performs alternating current charging by connecting an alternating current charging plug to the charging socket, the first resistance value is the first target value. When the vehicle does not perform alternating current charging, the first resistor is not powered, and the first resistance value may be infinity.

When the vehicle performs direct current charging by connecting a direct current charging plug to the charging socket, the second resistance value is the second target value. When the vehicle does not perform direct current charging, the second resistor is not powered, and the second resistance value may be infinity.

In a case in which the second resistance value is the second target value, it may be determined that the charging socket is connected to the direct current charging plug, and the charging type of the vehicle is the first direct current charging or the second direct current charging.

Whether the charging type is the first direct current charging or the second direct current charging may be determined according to heat generated during charging of the vehicle.

The heat generated during charging of the vehicle may be determined by using the following formula:

$$Q = I^2 Rt.$$

Q is heat generated during charging of the vehicle, I is an instantaneous current during charging, R is a resistance value of an inherent resistance of a cable in a direct current charging loop, and t is a charging time.

It is determined that the charging type is the first direct current charging when the heat generated in the process of charging the vehicle is greater than or equal to a preset heat threshold. It is determined that the charging type is the second direct current charging when the heat generated in the process of charging the vehicle is less than the heat threshold.

Step S2200: A heating component corresponding to the charging type is selected from a heating device according to the charging type of the vehicle to serve as a target heating device. The heating device includes a heat conduction component and a heating component, and the heat conduction component is configured to conduct heat energy generated during charging of the vehicle to the charging socket to heat the charging socket. The heating component is configured to heat the charging socket.

In an embodiment of the present disclosure, the selecting, from a heating device according to the charging type of the vehicle, a heating component corresponding to the charging type to serve as a target heating device may include: selecting the heat conduction component as the target heating device when the charging type of the vehicle is the first charging type; and selecting the heating component as the target heating device when the charging type of the vehicle is the second charging type.

Step S2300: The target heating device is controlled to heat the charging socket.

When the target heating device is the heating component, the heating component may be controlled to convert electric energy into heat energy, to heat the charging socket.

When the vehicle performs alternating current charging or low-power second direct current charging, because the direct current charging conductor generates less heat, sufficient heat cannot be provided for heating the charging socket. Therefore, the heating component needs to be additionally started to heat the charging socket.

When the target heating device is the heat conduction component, the heat conduction component may be controlled to conduct, to the charging socket, heat energy generated in the process of charging the vehicle, so as to heat the charging socket.

When the vehicle performs high-power first direct current charging, heat energy generated in the process of charging the vehicle may include heat energy generated by the direct current charging conductor. When the vehicle performs high-power first direct current charging, a charging current is relatively large, and in this case, heat generated by the direct current charging conductor sharply increases. The heat energy generated by the direct current charging conductor is used to heat the charging socket, so that energy can be recycled and effectively reused.

In an embodiment of the present disclosure, the controlling the target heating device to heat the charging socket may include: controlling, in a case in which the charging type is alternating current charging, the heating component to heat an alternating current charging socket; controlling, in a case in which the charging type is second direct current charging, the heating component to heat a direct current charging socket; and controlling, in a case in which the charging type is first direct current charging, the heat conduction component to heat a direct current charging socket.

In this embodiment, the heating component that heats the direct current charging socket and the heating component that heats the alternating current charging socket may be a same heating component or may be different heating components.

In a case in which the heating component for heating the alternating current charging socket is a first heating component and the heating component for heating the direct current charging socket is a second heating component, the first heating component may be disposed near the alternating current charging socket, to heat the alternating current charging socket, and the second heating component may be disposed near the direct current charging socket, to heat the direct current charging socket.

According to the embodiments of the present disclosure, a heating component corresponding to a charging type of the vehicle is selected from a heating device to serve as a target heating device, and the target heating device is controlled to heat a charging socket, to resolve a problem that a charging connector is frozen and cannot be pulled out in the process of charging the vehicle. In addition, charging types of the vehicle are distinguished, and different heating components are controlled to heat the charging socket, so that energy for heating the charging socket can be properly allocated.

In an embodiment of the present disclosure, the controlling the target heating device to heat the charging socket may include: controlling, in a case in which a heating instruction is received, the target heating device to heat the charging socket.

In this embodiment, the vehicle or a terminal device configured to control the vehicle may be provided with a one-click heating button. When the charging socket has a to-be-thawed object, a user may click on the one-click heating button to trigger a heating instruction.

In an embodiment of the present disclosure, the method may further include: determining whether the charging socket has a to-be-thawed object; and the controlling the target heating device to heat the charging socket may include: controlling, when the charging socket has a to-be-thawed object, the target heating device to heat the charging socket.

In this embodiment, whether the charging socket has a to-be-thawed object may be determined according to a preset first frequency. The first frequency may be preset according to an application scenario or a specific requirement. For example, the first frequency may be an interval of 1 minute.

In an embodiment of the present disclosure, the determining whether the charging socket has a to-be-thawed object may include: controlling a camera to photograph the charging socket, to obtain a first image; and receiving the first image, and determining, according to the first image, whether the foreign object is a to-be-thawed object.

In this embodiment, the camera may be disposed near the charging socket and may photograph the charging socket.

Specifically, the first image may be compared with a preset to-be-thawed object image, to determine whether the first image includes a to-be-thawed object, and in a case in which the first image includes a to-be-thawed object, it is determined that the charging socket has the to-be-thawed object. In a case in which the first image includes no to-be-thawed object, it is determined that the charging socket has no to-be-thawed object.

In an embodiment of the present disclosure, the determining whether the charging socket has a to-be-thawed object may include: receiving sensor data collected by a foreign object detection sensor; determining, according to the sensor data, whether the charging socket has a foreign object; controlling, in a case in which the charging socket has a foreign object, a camera to photograph the charging socket, to obtain a first image; and receiving the first image, and determining, according to the first image, whether the foreign object is a to-be-thawed object.

In this embodiment, the foreign object detection sensor and the camera detect whether the charging socket has a to-be-thawed object, so that a detection result is more accurate. In addition, when it is determined, according to sensor data collected by the foreign object detection sensor, that the charging socket has a foreign object, it is determined, according to the first image obtained by photographing the charging socket by the camera, whether the foreign object is a to-be-thawed object, so that power consumption of the vehicle can be reduced.

In an embodiment of the present disclosure, the method may further include: determining whether the charging socket has a to-be-thawed object and whether a current temperature of the charging socket is less than or equal to a preset first temperature threshold; and the controlling the target heating device to heat the charging socket may include: controlling, when the charging socket has a to-be-thawed object and the current temperature of the charging socket is less than or equal to the first temperature threshold, the target heating device to heat the charging socket.

In an example, the determining whether the charging socket has a to-be-thawed object and whether a current temperature of the charging socket is less than or equal to a preset first temperature threshold may include: controlling a camera to photograph the charging socket, to obtain a first image; receiving the first image, and determining, according to the first image, whether the charging socket has a to-be-thawed object; and controlling, in a case in which the charging socket has a to-be-thawed object, the temperature sensor to obtain the current temperature of the charging socket, and determining whether the current temperature of the charging socket is less than or equal to the first temperature threshold.

In another example, the determining whether the charging socket has a to-be-thawed object and whether a current temperature of the charging socket is less than or equal to a preset first temperature threshold may include: receiving sensor data collected by a foreign object detection sensor; determining, according to the sensor data, whether the charging socket has a foreign object; controlling, in a case in which the charging socket has a foreign object, a camera to photograph the charging socket, to obtain a first image; and receiving the first image, and determining, according to the first image, whether the foreign object is a to-be-thawed object; and controlling, in a case in which the charging socket has a to-be-thawed object, the temperature sensor to obtain the current temperature of the charging socket, and determining whether the current temperature of the charging socket is less than or equal to the first temperature threshold.

In this embodiment, the first temperature threshold may be preset according to an application scenario or a specific requirement. For example, the first temperature threshold may be 0 degrees Celsius.

In this embodiment, in a case in which it is detected, when it is detected that the charging socket has a foreign object and according to the first image obtained by photographing the charging socket, that the foreign object of the charging socket is a to-be-thawed object, and it is detected that the temperature of the charging socket is less than or equal to the first temperature threshold, the to-be-thawed object of the charging socket is comprehensively identified, and a heat event of the charging socket is triggered to occur, which can effectively improve accuracy of an identification result of whether the charging socket has a to-be-thawed object.

In an embodiment of the present disclosure, the method may further include: determining, in a process of controlling the target heating device to heat the charging socket, whether the charging socket has a to-be-thawed object; and controlling, when the charging socket has no to-be-thawed object, the target heating device to stop heating the charging socket.

In an embodiment, the determining whether the charging socket has a to-be-thawed object includes:

determining, in a case in which the current temperature of the charging socket is greater than or equal to a preset second temperature threshold, that the charging socket has no to-be-thawed object; and determining, in a case in which the current temperature of the charging socket is less than the second temperature threshold, that the charging socket has a to-be-thawed object.

The second temperature threshold in this embodiment may be preset according to an application scenario or a specific requirement. For example, the second temperature threshold may be 2 degrees Celsius.

In a case in which the current temperature of the charging socket is greater than or equal to the second temperature threshold, it indicates that the to-be-thawed object of the charging socket has been thawed. Therefore, heating of the charging socket can be stopped, so as to avoid energy loss caused due to constant heating.

In an embodiment, the determining whether the charging socket has a to-be-thawed object includes: controlling, in a case in which the current temperature of the charging socket is greater than or equal to a preset second temperature threshold, the camera to photograph the charging socket, to obtain a second image; and receiving the second image, and identifying, according to the second image, whether the charging socket has a to-be-thawed object.

In this embodiment, a result obtained by determining, according to the temperature of the charging socket only, whether the to-be-thawed object of the charging socket has been thawed may be inaccurate. Therefore, in a case in which it is detected that the current temperature of the charging socket is greater than the preset second temperature threshold, the camera may be controlled to photograph the charging socket, to obtain the second image, and whether the to-be-thawed object of the charging socket has been thawed is further determined according to the second image, so that an obtained detection result of whether the charging socket has a to-be-thawed object is more accurate.

In an embodiment of the present disclosure, the method may further include:

controlling a temperature sensor to obtain the current temperature of the charging socket; and selecting a heating mode corresponding to the current temperature from multiple heating modes to serve as a target heating mode; and the controlling the target heating device to heat the charging socket includes: controlling the target heating device to heat the charging socket by using the target heating mode.

In this embodiment, multiple heating modes and a temperature range corresponding to each heating mode may be preset according to an application scenario or a specific requirement. For example, it may be set that a temperature range corresponding to a first-level heating mode is (-10, 0], a temperature range corresponding to a second-level heating mode is (-20, -10], and a temperature range corresponding to a third-level heating mode is (-∞, -20].

The selecting a heating mode corresponding to the current temperature from multiple heating modes to serve as a target heating mode may include: determining a temperature range of the current temperature, and using a heating mode corresponding to the temperature range of the current temperature as the target heating mode. Therefore, when the current temperature is -5 degrees Celsius, it may be determined that a corresponding target heating mode is the first-level heating mode. When the current temperature is -12 degrees Celsius, it may be determined that a corresponding target heating mode is the second-level heating mode. When the current temperature is -28 degrees Celsius, it may be determined that a corresponding target heating mode is the third-level heating mode.

In an embodiment in which the target heating device is the heating component, multiple heating components may be disposed in the vehicle. The controlling the target heating device to heat the charging socket by using the target heating mode may be controlling a number of heating components corresponding to the target heating mode to start to heat the charging socket. Specifically, a number of to-be-started heating components corresponding to each heating mode may be preset according to an application scenario or a specific requirement.

For example, it may be set that a number of to-be-started heating components corresponding to the first-level heating mode is 1, a number of to-be-started heating components corresponding to the second-level heating mode is 2, and a number of to-be-started heating components corresponding to the third-level heating mode is 3. Therefore, in a case in which the target heating mode is the first-level heating mode, one heating component may be controlled to start to heat the charging socket. In a case in which the target heating mode is the second-level heating mode, two heating components may be controlled to start to heat the charging socket. In a case in which the target heating mode is the third-level heating mode, three heating components may be controlled to start to heat the charging socket.

In an embodiment in which the target heating device is the heat conduction component, multiple heat conduction components may be disposed in the vehicle. The controlling the target heating device to heat the charging socket by using the target heating mode may be controlling a number of heat conduction components corresponding to the target heating mode to connect to the direct current charging conductor to heat the charging socket. Specifically, a number of heat conduction components that correspond to each heating mode and that are connected to the direct current charging conductor may be preset according to an application scenario or a specific requirement.

For example, it may be set that a number of heat conduction components that correspond to the first-level heating mode and that are connected to the direct current charging conductor is 1, a number of heat conduction components that correspond to the second-level heating mode and that are connected to the direct current charging conductor is 2, and a number of heat conduction components that correspond to the third-level heating mode and that are connected to the direct current charging conductor is 3. Therefore, in a case in which the target heating mode is the first-level heating mode, one heat conduction component may be controlled to connect to the direct current charging conductor to heat the charging socket. In a case in which the target heating mode is the second-level heating mode, two heat conduction components may be controlled to connect to the direct current charging conductor to heat the charging socket. In a case in which the target heating mode is the third-level heating mode, three heat conduction components may be controlled to connect to the direct current charging conductor to heat the charging socket.

In an embodiment of the present disclosure, the method may further include: controlling, in response to a heating instruction in a case in which the vehicle is fully charged or the vehicle is not charged, the heating component to heat the charging socket.

In this embodiment, in the case in which the vehicle is fully charged, the vehicle is in a sleep state, and the charging connector may be frozen and cannot be pulled out. When the vehicle is not charged, the charging port cover may be frozen and cannot be opened. In this case, a user may click on a one-click heating button in the vehicle or a terminal device configured to control the vehicle, to trigger the heating instruction. The vehicle may control, in response to the heating instruction, the heating device to heat the charging socket.

Specifically, the vehicle may control, in response to the heating instruction, the heating device to heat both the alternating current charging socket and the direct current charging socket.

Further, when the user clicks on the one-click heating button in the vehicle or the terminal device, the vehicle or the terminal may provide an option of the alternating current charging socket and an option of the direct current charging socket for the user to select. In a case in which the user selects the option of the alternating current charging socket, the vehicle may control the heating device to heat the alternating current charging socket. When the user selects the option of the direct current charging socket, the vehicle may control the heating device to heat the direct current charging socket.

In an embodiment in which the vehicle is fully charged, in a case in which the user clicks on the one-click heating button in the vehicle or the terminal device configured to control the vehicle, the vehicle may detect whether the charging socket to which the charging connector is connected is the alternating current charging socket or the direct current charging socket. In a case in which it is detected that the charging socket to which the charging connector is connected is the alternating current charging socket, the heating device may be controlled to heat the alternating current charging socket. In a case in which it is detected that the charging socket to which the charging connector is connected is the direct current charging socket, the heating device may be controlled to heat the direct current charging socket.

In this embodiment, the charging socket may be heated in the case in which the vehicle is fully charged or the vehicle is not charged, so that the to-be-thawed object attaching to the charging socket or the charging port cover is thawed.

In an embodiment of the present disclosure, the method may further include: detecting, in response to a heating instruction, whether a current temperature of the charging socket is less than or equal to a preset third temperature threshold; and controlling, in a case in which the current temperature is less than or equal to the third temperature threshold, the heating component to heat the charging socket; or skipping, in a case in which the current temperature is greater than the third temperature threshold, controlling the heating component to heat the charging socket.

In a case in which the current temperature is greater than the third temperature threshold, the charging socket or the charging port cover has no to-be-thawed object, and the charging socket does not need to be heated.

In an embodiment of the present disclosure, in any case in which the vehicle is being charged, the vehicle is fully charged, or the vehicle is not charged, in the process of controlling the target heating device to heat the charging socket, the method may further include: detecting a current temperature of the charging socket; and selecting a heating mode corresponding to the current temperature from multiple heating modes to serve as a target heating mode; and the controlling the target heating device to heat the charging socket may include: controlling the target heating device to heat the charging socket by using the target heating mode.

**< Example>**

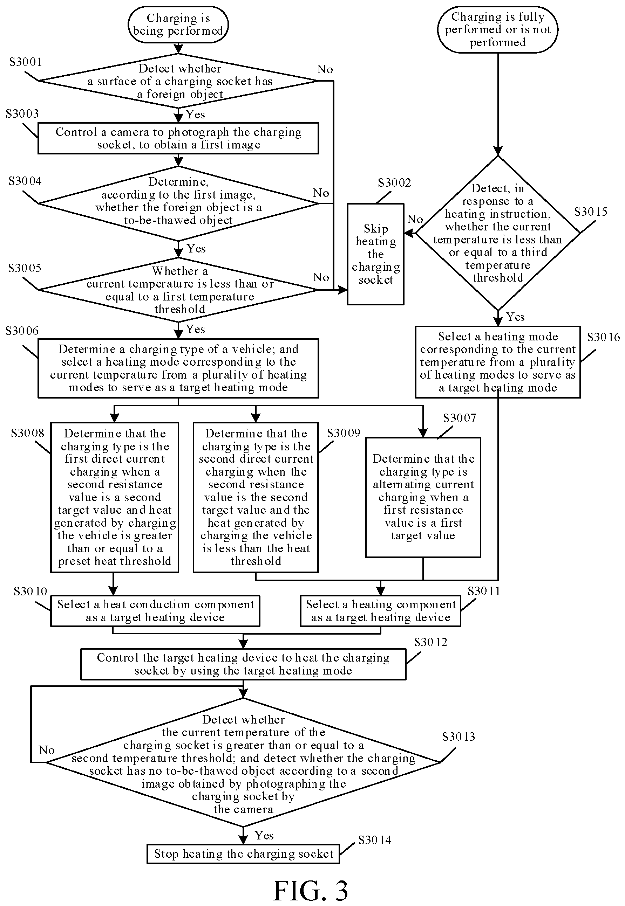

FIG. 3 is a flowchart of an example of a method for heating a charging socket according to an embodiment of the present disclosure.

In a process of charging a vehicle, as shown in FIG. 3, the method may include the following steps S3001 to S3013:

Step S3001: Whether a charging socket has a foreign object is detected, and if not, step S3002 is performed, or if yes, step S3003 is performed.

Step S3002: Heating of the charging socket is skipped.

Step S3003: A camera is controlled to photograph the charging socket, to obtain a first image.

Step S3004: The first image is received, whether a foreign object of the charging socket is a to-be-thawed object is determined according to the first image, and if not, step S3002 is performed, or if yes, step S3005 is performed.

Step S3005: A temperature sensor is controlled to obtain a current temperature of the charging socket, whether the current temperature is less than or equal to a first temperature threshold is determined; and if not, step S3002 is performed, or if yes, step S3006 is performed.

Step S3006: A charging type of the vehicle is determined; and a heating mode corresponding to the current temperature is selected from multiple heating modes to serve as a target heating mode.

Step S3007: It is determined that the charging type is alternating current charging when a first resistance value is a first target value.

Step S3008: It is determined that the charging type is first direct current charging when a second resistance value is a second target value and heat generated by charging the vehicle is greater than or equal to a preset heat threshold.

Step S3009: It is determined that the charging type is second direct current charging when the second resistance value is the second target value and the heat generated by charging the vehicle is less than the heat threshold.

Step S3010: A heat conduction component is selected as a target heating device.

Step S3011: A heating component is selected as a target heating device.

Step S3012: The target heating device is controlled to heat the charging socket by using the target heating mode.

Step S3013: Whether the current temperature of the charging socket is greater than or equal to a second temperature threshold is detected; the camera is controlled to photograph the charging socket, to obtain a second image; whether the charging socket has no to-be-thawed object is detected; and if yes, step S3014 is performed, or if not, step S3013 continues to be performed.

Step S3014: Heating of the charging socket is stopped.

In a case in which the vehicle is fully charged or is not charged, as shown in FIG. 3, the method may include the following steps:

Step S3015: Whether a current temperature of the charging socket is less than or equal to a preset third temperature threshold is detected in response to a heating instruction; and if yes, step S3016 is performed, or if not, step S3002 is performed.

Step S3016: A heating mode corresponding to the current temperature is selected from multiple heating modes to serve as a target heating mode.

Step S3011: The heating component is controlled to heat the charging socket by using the target heating mode.

Step S3013: Whether the current temperature of the charging socket is greater than or equal to a second temperature threshold is detected; the camera is controlled to photograph the charging socket, to obtain a second image; whether the charging socket has no to-be-thawed object is detected; and if yes, step S3014 is performed, or if not, step S3013 continues to be performed.

Step S3014: Heating of the charging socket is stopped.

### < Vehicle Embodiment >

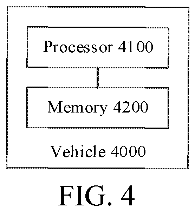

FIG. 4 is a schematic structural diagram of a vehicle that can be configured to implement a method for heating a charging socket according to an embodiment of the present disclosure.

A vehicle 4000 shown in FIG. 4 may include a processor 4100 and a memory 4200. The memory 4200 is configured to store a computer program. The processor 4100 is configured to control the vehicle to perform the method according to any embodiment of this specification under control by the computer program.

The processor 4100 is used as a main component of an electronic control unit (ECU) of the vehicle, and is configured to execute a computer program. The computer program may be written by using an instruction set of an architecture such as x47, Arm, RISC, MIPS, or SSE.

The memory 4200 includes, for example, a read-only memory (ROM), a random access memory (RAM), and a non-volatile memory such as a hard disk, and is configured to store the computer program and the like.

The vehicle in this embodiment may be a vehicle provided with a power battery, and specifically may be a pure electric vehicle, or may be a hybrid vehicle.

In an example, the vehicle may further have at least one of another hardware structure such as an engine, a motor controller, a sensing device, an input device, an interface device, an output device, a motor, and a power battery. This is not limited herein.

A rear end (an end connected to a flywheel) of the engine may be connected to an input end of a decelerator by using a clutch, and an output end of the decelerator is connected to a wheel axis, so as to drive a wheel to rotate by using the engine.

The motor controller is configured to control an action of the motor according to a control instruction sent by the processor 4100, for example, control the motor to output a torque, to drive the wheel axis to rotate. For another example, the motor is controlled to feed back electric energy to the power battery.

The sensing device may include various sensors, for example, at least one of a rotational speed sensor, a posture sensor, a temperature sensor, a humidity sensor, and a pressure sensor.

The input device may include a key circuit, a touchscreen, a microphone, a knob circuit, an acceleration control apparatus with an acceleration pedal, a braking control apparatus with a braking pedal, and the like.

The interface device may include an earphone interface, a diagnosis interface of an on board diagnostics (OBD) system, a charging interface, a USB interface, and the like.

The output device may include a display screen, a speaker, various indicators, and the like.

When the motor is used as an electric motor, the power battery may be configured to provide electric energy for the motor.

### < Readable storage medium embodiment >

The present disclosure provides a computer-readable storage medium storing a computer program. The computer program is executed by a processor to perform the method according to any method embodiment of the present disclosure.

The present disclosure may be implemented as systems, methods, and/or computer program products. The computer program product may include a computer-readable storage medium storing a computer-readable program instruction used for enabling a processor to implement various aspects of the present disclosure.

The computer-readable storage medium may be a tangible device that can retain and store instructions used by an instruction execution device. The computer-readable storage medium may be, for example, but is not limited to, an electric storage device, a magnetic storage device, an optical storage device, an electromagnetic storage device, or a semiconductor storage device, or any suitable combination of the above. More specific examples (a non-exhaustive list) of the computer-readable storage medium include: a portable computer disk, a hard disk, a random access memory (RAM), a read-only memory (ROM), an erasable programmable read-only memory (EPROM or flash memory), a static random access memory (SRAM), a portable compact disc read only memory (CD-ROM), a digital versatile disc (DVD), a memory stick, a floppy disk, a mechanical encoding device, such as a punch card or a protrusion in a groove storing instructions, and any suitable combination thereof. The computer-readable storage medium used herein is not interpreted as a transitory signal, such as a radio wave or another freely propagated electromagnetic wave, an electromagnetic wave propagated through a wave guide or another transmission medium (for example, an optical pulse transmitted through a fiber cable), or an electrical signal transmitted through a wire.

The computer-readable program instruction described herein may be downloaded to each computing/-processing device from a computer-readable storage medium, or may be downloaded to an external computer or external storage device by using a network such as the Internet, a local area network, a wide area network and/or a wireless network. The network may include a copper transmission cable, optical transmission, wireless transmission, a router, a firewall, a switch, a gateway computer, and/or an edge server. A network adapter card or a network interface in each computing/processing device receives a computer-readable program instruction from the network and forwards the computer-readable program instruction for storage in a computer-readable storage medium in each computing/processing device.

The computer program instruction used for performing the operations of the present disclosure may be an assembler instruction, an instruction set architecture (ISA) instruction, a machine instruction, a machine related instruction, microcode, a firmware instruction, state setting data, or a source code or an object code written in any combination of one or more programming languages. The programming languages include an object-oriented programming language such as Smalltalk or C ++, and a conventional procedural programming language such as a "C" language or a similar programming language. The computer-readable program instruction may be completely executed on a user computer, partially executed on a user computer, executed as an independent software package, partially executed on a user computer and partially executed on a remote computer, or completely executed on a remote computer or server. For the case involving a remote computer, the remote computer may be connected to a computer of a user through any type of network including a LAN or a WAN, or may be connected to an external computer (for example, through the Internet by using an Internet service provider). In some embodiments, an electronic circuit, such as a programmable logic circuit, a field programmable gate array (FPGA), or a programmable logic array (PLC), is customized by using state information of the computer-readable program instruction. The electronic circuit may execute the computer-readable program instruction, to implement various aspects of the present disclosure.

The foregoing describes the aspects of the present disclosure with reference to flowcharts and/or block diagrams of the method, the device (system), and the computer program product according to the embodiments of the present disclosure. It should be understood that each block in the flowchart and/or block diagram and a combination of blocks in the flowchart and/or block diagram may be implemented by computer-readable program instructions.

These computer-readable program instructions can be provided to a processor of a general-purpose computer, a special-purpose computer, or another programmable data processing device to generate a machine, such that when the instructions are executed by the processor of the computer or another programmable data processing device, a device for implementing functions/acts specified in one or more blocks of the flowcharts and/or block diagrams is generated. These computer-readable program instructions may also be stored in a computer-readable storage medium, and these instructions enable a computer, a programmable data processing device, and/or another device to work in a specific manner. Therefore, the computer-readable medium storing instructions includes an article of manufacture, which includes instructions for implementing various aspects of functions/acts specified in one or more blocks of the flowcharts and/or block diagrams.

The computer-readable program instructions may also be loaded onto a computer or another programmable data processing device or another device to cause a series of operational steps to be performed on the computer or another programmable data processing device or another device, to produce a computer-implemented process such that the instructions executed on the computer or another programmable data processing device or another device implement functions/acts specified in one or more blocks of the flowcharts and/or block diagrams.

The flowcharts and block diagrams in the accompanying drawings illustrate the architecture, functionality, and operation of possible implementations of systems, methods and computer program products according to various embodiments of the present disclosure. In this regard, each block in a flowchart or a block diagram may represent a module, a program segment, or a part of an instruction. The module, the program segment, or the part of the instruction includes one or more executable instructions used for implementing designated logic functions. In some implementations used as substitutes, functions annotated in blocks may alternatively occur in a sequence different from that annotated in an accompanying drawing. For example, actually two blocks shown in succession may be performed basically in parallel, and sometimes the two blocks may be performed in a reverse sequence. This depends on a related function. It should also be noted that, each block in a block diagram and/or a flowchart and a combination of blocks in the block diagram and/or the flowchart may be implemented by using a dedicated hardware-based system configured to perform a specified function or operation, or may be implemented by using a combination of dedicated hardware and a computer instruction. It is well-known to a person skilled in the art that implementation by means of hardware, implementation by means of software, and implementation by means of a combination of software and hardware are all equivalent.

The embodiments of the present disclosure have been described above. The foregoing description is illustrative and not exhaustive, and is not limited to the disclosed embodiments. Many modifications and changes made without departing from the scope and spirit of the described embodiments are obvious to a person of ordinary skill in the art. The terms used in this specification are chosen to best explain principles of the embodiments, actual applications, or technical improvements in the market, or enable a person of ordinary skill in the art to understand the embodiments disclosed in this specification. The scope of the present disclosure is limited only by the appended claims.

## Claims

1. A method for heating a charging socket, the method comprising:

    determining a charging type of a vehicle, the charging type comprising a first charging type and a second charging type, and the first charging type being different from the second charging type;
    selecting, from a heating device according to the charging type, a heating component corresponding to the charging type to serve as a target heating device, the heating device comprising a heat conduction component and a heating component, the heat conduction component being configured to conduct heat energy generated during charging of the vehicle to the charging socket to heat the charging socket, and the heating component being configured to heat the charging socket; and
    controlling the target heating device to heat the charging socket.

2. The method according to claim 1, wherein the selecting, from a heating device according to the charging type, a heating component corresponding to the charging type to serve as a target heating device comprises:

    selecting the heat conduction component as the target heating device when the charging type is the first charging type; and
    selecting the heating component as the target heating device when the charging type is the second charging type.

3. The method according to claim 2, wherein the first charging type comprises first direct current charging, the second charging type comprises alternating current charging and second direct current charging, and a power of the first direct current charging is greater than a power of the second direct current charging; and the determining a charging type of a vehicle comprises:

    determining that the charging type is the alternating current charging when a first resistance value is a first target value, the first resistance value being a value of a first resistor corresponding to the alternating current charging;
    determining that the charging type is the first direct current charging when a second resistance value is a second target value and heat generated by charging the vehicle is greater than or equal to a preset heat threshold; or determining that the charging type is the second direct current charging when the second resistance value is the second target value and the heat generated by charging the vehicle is less than the heat threshold; the second resistance value being a value of a second resistor corresponding to direct current charging.

4. The method according to any one of claims 1 to 3, further comprising:

    determining whether the charging socket has a to-be-thawed object; and
    the controlling the target heating device to heat the charging socket comprises:
    controlling, when the charging socket has a to-be-thawed object, the target heating device to heat the charging socket.

5. The method according to claim 4, wherein the determining whether the charging socket of the vehicle has a to-be-thawed object comprises:

    receiving sensor data collected by a foreign object detection sensor;
    determining, according to the sensor data, whether the charging socket has a foreign object;
    controlling, in a case in which the charging socket has a foreign object, a camera to photograph the charging socket, to obtain a first image; and
    receiving the first image, and determining, according to the first image, whether the foreign object is a to-be-thawed object.

6. The method according to any one of claims 1 to 3, further comprising:

    determining whether the charging socket has a to-be-thawed object and whether a current temperature of the charging socket is less than or equal to a preset first temperature threshold; and
    the controlling the target heating device to heat the charging socket comprises:
    controlling, when the charging socket has a to-be-thawed object and the current temperature of the charging socket is less than or equal to the first temperature threshold, the target heating device to heat the charging socket.

7. The method according to claim 6, wherein the determining whether the charging socket has a to-be-thawed object and whether a current temperature of the charging socket is less than or equal to a preset first temperature threshold comprises:

controlling a camera to photograph the charging socket, to obtain a first image;
receiving the first image, and determining, according to the first image, whether the charging socket has a to-be-thawed object; and
controlling, in a case in which the charging socket has a to-be-thawed object, the temperature sensor to obtain the current temperature of the charging socket, and determining whether the current temperature of the charging socket is less than or equal to the first temperature threshold.

8. The method according to any one of claims 1 to 7, further comprising:

determining, in a process of controlling the target heating device to heat the charging socket, whether the charging socket has a to-be-thawed object; and
controlling, when the charging socket has no to-be-thawed object, the target heating device to stop heating the charging socket.

9. The method according to claim 8, wherein the determining whether the charging socket has a to-be-thawed object comprises:

controlling, in a case in which the current temperature of the charging socket is greater than or equal to a preset second temperature threshold, the camera to photograph the charging socket, to obtain a second image; and
receiving the second image, and identifying, according to the second image, whether the charging socket has a to-be-thawed object.

10. The method according to any one of claims 1 to 9, further comprising:

controlling a temperature sensor to obtain the current temperature of the charging socket; and
selecting a heating mode corresponding to the current temperature from a plurality of heating modes to serve as a target heating mode; and
the controlling the target heating device to heat the charging socket comprises:
controlling the target heating device to heat the charging socket by using the target heating mode.

11. A vehicle, comprising a processor and a memory, the memory being configured to store a computer program, and the processor being configured to perform the method according to any one of claims 1 to 10 under control by the computer program.

12. A computer-readable storage medium, having a computer program stored therein, the computer program being executed by a processor to perform the method according to any one of claims 1 to 10.

```
┌──────────────────────────────────────────────────────────────────────────┐
│  ┌────────────────────────┐                    ┌────────────────────────┐  │
│  │     Foreign object     │                    │    Charging socket     │  │
│  │ detection sensor 1300  │                    │          1100          │  │
│  └────────────────────────┘                    └────────────────────────┘  │
│  ┌────────────────────────┐   ┌──────────────┐ ┌────────────────────────┐  │
│  │      Camera 1400       │──▶│ Controller   │ │ │       Heating        │ │ │
│  └────────────────────────┘   │     1600     │◀│ │  component 1210      │ │ │
│  ┌────────────────────────┐   └──────────────┘ │ ├────────────────────────┤ │
│  │   Temperature sensor   │                    │ │   Heat conduction    │ │ │
│  │          1500          │                    │ │   component 1220     │ │ │
│  └────────────────────────┘                    │ └────────────────────────┘ │
│        Charging socket                         │   Heating device 1200    │
│        component 1000                          └────────────────────────────┘
└──────────────────────────────────────────────────────────────────────────┘
```

## FIG. 1

```
┌────────────────────────────────────────────────────────────┐   S2100
│           Determine a charging type of a vehicle            │
└────────────────────────────────────────────────────────────┘
                              │
                              ▼
┌────────────────────────────────────────────────────────────┐   S2200
│ Select a heating component corresponding to the charging    │
│ type from a heating device according to the charging type   │
│ of the vehicle to serve as a target heating device          │
└────────────────────────────────────────────────────────────┘
                              │
                              ▼
┌────────────────────────────────────────────────────────────┐   S2300
│   Control the target heating device to heat the charging    │
│   socket                                                    │
└────────────────────────────────────────────────────────────┘
```

## FIG. 2

FIG. 3

Processor 4100

Memory 4200

Vehicle 4000

FIG. 4

## INTERNATIONAL SEARCH REPORT

| International application No. |
| --- |
| **PCT/CN2023/132266** |

| A. | CLASSIFICATION OF SUBJECT MATTER |
| --- | --- |

H01R13/66(2006.01)i

According to International Patent Classification (IPC) or to both national classification and IPC

| B. | FIELDS SEARCHED |
| --- | --- |

Minimum documentation searched (classification system followed by classification symbols)

IPC:H01R

Documentation searched other than minimum documentation to the extent that such documents are included in the fields searched

Electronic data base consulted during the international search (name of data base and, where practicable, search terms used)

CNTXT, ENTXT, ENTXTC, DWPI, CNKI: 充电, 加热, 插座, 车辆, 导热, charge, heat, socket, car, heat conduction

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| Y | CN 109004464 A (PORSCHE AG) 14 December 2018 (2018-12-14) <br> description, paragraphs 5-59, and figures 1-4 | 1-12 |
| Y | CN 111130179 A (ZHUHAI GUANGTONG AUTOMOBILE CO., LTD. et al.) 08 May 2020 (2020-05-08) <br> description, paragraphs 23-59, and figures 1-2 | 1-12 |
| A | CN 212950215 U (BEIJING FOTON DAIMLER AUTOMOTIVE CO., LTD.) 13 April 2021 (2021-04-13) <br> entire document | 1-12 |
| A | CN 115290998 A (STATE GRID BEIJING ELECTRIC POWER COMPANY et al.) 04 November 2022 (2022-11-04) <br> entire document | 1-12 |
| A | JP 2020156250 A (SUBARU CORPORATION) 24 September 2020 (2020-09-24) <br> entire document | 1-12 |

☐ Further documents are listed in the continuation of Box C.   ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **05 February 2024** | **07 February 2024** |

| Name and mailing address of the ISA/CN | Authorized officer |
| --- | --- |
| **China National Intellectual Property Administration (ISA/CN)** <br> **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

International application No.

**PCT/CN2023/132266**

| Patent document cited in search report | | | Publication date (day/month/year) | Patent family member(s) | | | Publication date (day/month/year) |
|---|---|---|---|---|---|---|---|
| CN | 109004464 | A | 14 December 2018 | None | | | |
| CN | 111130179 | A | 08 May 2020 | None | | | |
| CN | 212950215 | U | 13 April 2021 | None | | | |
| CN | 115290998 | A | 04 November 2022 | None | | | |
| JP | 2020156250 | A | 24 September 2020 | JP | 7299727 | B2 | 28 June 2023 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202211725899